# FASCICULE DE BREVET EUROPEEN

(11) **EP 0 439 412 B1**
(45) Date de publication et mention de la délivrance du brevet: **14.05.1997**
(21) Numéro de dépôt: 91420014.2
(22) Date de dépôt: 22.01.1991
(51) Int. Cl.: G06F 7/00, H03M 9/00

(54) **Sérialiseur/désérialiseur**
Schaltkreis zur Serialisierung und Deserialisierung
Serializer/deserializer

(30) Priorité: 26.01.1990 FR 9001099
(43) Date de publication de la demande: 31.07.1991
(73) Titulaire: SGS-THOMSON MICROELECTRONICS S.A., 94250 Gentilly (FR)
(72) Inventeur: Chaisemartin, Philippe, F-38190 Brignoud (FR); Artieri, Alain, F-38240 Meylan (FR)
(74) Mandataire: de Beaumont, Michel

(56) Documents cités:
- EP-A- 0 267 729
- EP-A- 0 298 002
- FR-A- 2 278 114
- US-A- 4 769 790

## Description

La présente invention concerne le domaine du traitement des données et plus particulièrement un dispositif permettant de mettre sous forme série des données arrivant sous forme parallèle, c'est-à-dire un sérialiseur, ou de mettre sous forme parallèle des données arrivant sous forme série, c'est-à-dire un désérialiseur.

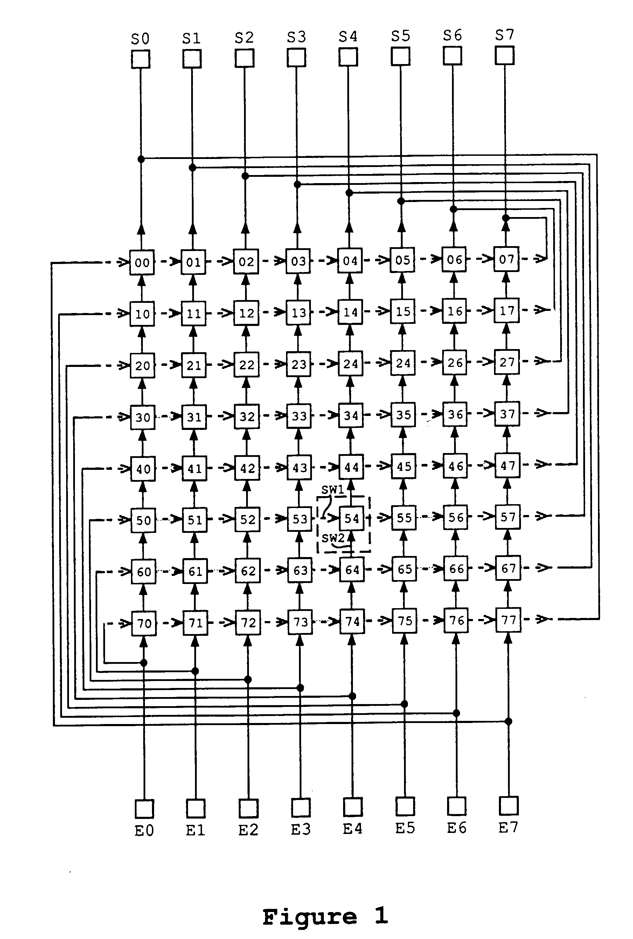

La figure 1 représente de façon schématique et symbolique un sérialiseur/désérialiseur pour des données en mots de 8 bits. On peut voir dans cette figure des registres disposés matriciellement dont chacun est désigné par le couple ij de son numéro de rangée et de son numéro de colonne. Ainsi, la première rangée comprend les registres 00 à 07 et la dernière rangée les registres 70 à 77. Dans cette figure, les flèches désignent des interrupteurs commandés, les flèches en trait plein désignant des interrupteurs fermés pendant un premier cycle de fonctionnement et les flèches en pointillés ou en grisé désignant des interrupteurs fermés pendant un deuxième cycle de fonctionnement.

Les registres de la première colonne (colonne 0) et les registres de la dernière rangée (rangée 7) sont couplés à des bornes d'entrée E0 à E7. Les registres de la première rangée (00 à 07) et de la dernière colonne (07 à 77) sont couplés à des bornes de sortie S0 et S7.

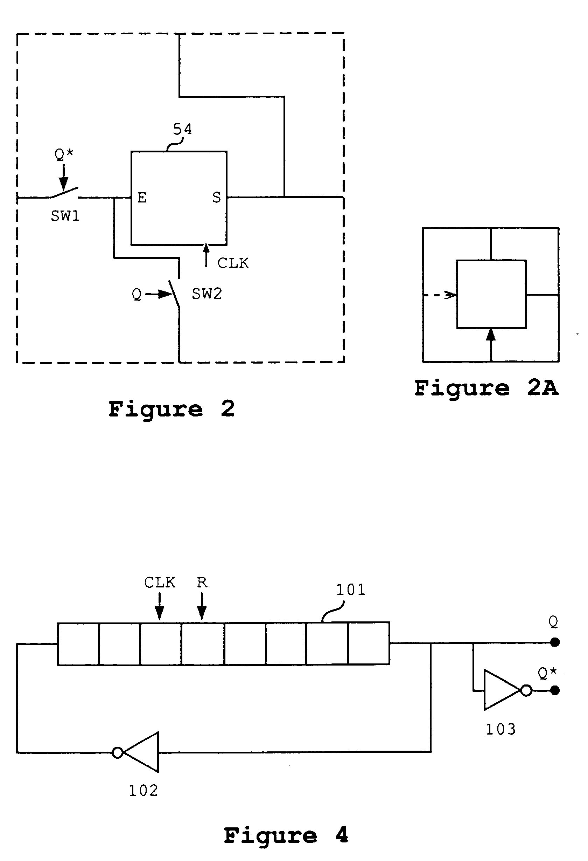

Une cellule élémentaire de la matrice de la figure 1 est entourée de pointillés autour du registre 54 en figure 1 et cette cellule est représentée selon un autre mode de représentation en figures 2 et 2A. Le registre 54 est un registre d'un bit qui comprend une entrée E et une sortie S et qui est actionné au rythme du signal d'horloge CLK du circuit. L'entrée E est reliée à la cellule adjacente à gauche par un premier commutateur SW1 actionné par un signal Q* (complément du signal Q) et à la cellule adjacente inférieure par un second commutateur SW2 actionné par le signal Q. La sortie S du registre 54 est reliée à la cellule adjacente de la rangée supérieure, c'est-à-dire qu'elle est reliée au registre 44 par l'intermédiaire du commutateur SW2 associé à celui-ci et la cellule de droite de la même rangée, c'est-à-dire qu'elle est reliée au commutateur SW1 du registre 55.

Le fonctionnement du circuit de la figure 1 en sérialiseur va d'abord être expliqué. On suppose qu'initialement tous les registres sont vides et que tous les commutateurs SW1 (flèches en grisés) sont passants tandis que tous les commutateurs SW2 sont ouverts. Des mots de données successifs sous forme parallèle arrivent au rythme de l'horloge CLK. Ces mots se déplacent horizontalement de registre en registre dans la matrice. Ainsi, au bout de 8 coups d'horloge, le premier mot introduit occupe les cases 07 à 77 de la dernière colonne, le deuxième mot occupe les cases 06 à 76 de l'avant-dernière colonne, ... et le huitième mot occupe les cases 00 à 70 de la première colonne.

A ce moment, au bout de huit cycles, on inverse l'état des commutateurs SW1 et SW2 et on continue à actionner les registres et à introduire des mots de données au rythme de l'horloge CLK. Les bits contenus dans chacune des cellules se décaleront alors verticalement. Ainsi, sur les sorties S0 à S7 apparaîtront sous forme série les huit mots introduits dans la matrice. Tandis que les premiers bits de ces mots sortent des registres de la première rangée (rangée supérieure), le mot de données suivant sur les entrées E0 à E7 entrera sur la dernière rangée (rangée inférieure).

En répétant cette opération, c'est-à-dire en commutant les commutateurs de la matrice tous les huit coups d'horloge, on obtiendra séquentiellement des mots série sur les sorties S0 à S7 tandis que des mots sous forme parallèle sont introduits sur les entrées E0 à E7, sans aucune rupture de séquence.

On notera que le sérialiseur qui vient d'être décrit fonctionne sans aucune modification ni dans sa structure ni dans son mode de commande en tant que désérialiseur. En effet, si sur les entrées E0 à E7 arrivent huit mots série, on obtiendra sur les sorties S0 à S7 ces mots mis sous forme parallèle.

Un dispositif comparable est décrit dans la publication EP-A-0 298 002.

Un inconvénient du dispositif à structure matricielle carrée illustré en figure 1 est qu'une place importante est occupée par les connexions existant, d'une part, entre les entrées et les registres de la dernière rangée et de la première colonne, d'autre part, entre les sorties et les registres de la première rangée et de la dernière colonne.

En pratique, une matrice 8-8 dont la cellule élémentaire est telle qu'illustrée en figure 2 occupera, dans une technologie CMOS dans laquelle la longueur minimale d'une grille de transistor est de 1,2 micromètres, une surface de l'ordre de 0,2 mm². Dans cette même technologie, on ne peut miniaturiser à l'extrême les dimensions des métallisations de connexion et celles-ci occuperont une surface de l'ordre de 0,13 mm², qui est loin d'être négligeable par rapport à la surface des composants actifs du dispositif.

Ainsi, un object de la présente invention est de prévoir une structure de sérialiseur/désérialiseur à surface réduite.

Un autre objet de la présente invention est de prévoir un sérialiseur/désérialiseur adapté au traitement de données série sous forme de dibits successifs.

Ces objets de la présente invention sont atteints en prévoyant un sérialisateur/désérialisateur de flux de données à n bits décalés au rythme d'une horloge (CLK), comprenant :
une matrice à n rangées et n colonnes de registres de 1 bit dont chacun est connecté par son entrée à un premier commutateur relié à la sortie du registre de la même rangée et de la colonne de rang inférieur et à un deuxième commutateur connecté à la sortie du registre de la même colonne et de la rangée de rang supérieur,
des moyens de commande pour fermer alternativement tous les n coups d'horloge les premiers commutateurs et les deuxièmes commutateurs,
des bornes d'entrée reliées aux registres de la colonne de rang inférieur et de la rangée de rang supérieur,
des bornes de sortie reliées aux registres de la colonne de rang supérieur et de la rangée de rang inférieur,
dans lequel les cellules de la matrice sont disposées en triangle, les cellules étant disposées les unes par rapport aux autres selon la structure qui correspont à un repliement d'une matrice carrée autour de sa diagonale.

Selon un mode de réalisation de la présente invention les moyens de commande comprennent un registre à n cases rebouclé sur lui-même par un inverseur et actionné au rythme de l'horloge.

Selon un mode de réalisation de la présente invention le sérialiseur/désérialiseur est adapté à des flux de données à 2n bits, dans lequel les données série sont sous forme de dibits, et comprend deux matrices, les cellules de chaque matrice étant géométriquement disposées en triangle, et les deux structures repliées étant imbriquées, deux entrées de même rang des deux matrices étant associées à deux bits de rang successifs d'un flux de données parallèle ou à un dibit d'un flux de dibits série.

Ces objets, caractéristiques et avantages ainsi que d'autres de la présente invention seront exposés plus en détail dans la description suivante de modes de réalisation particuliers faite en relation avec les figures jointes parmi lesquelles :
la figure 1 représente un sérialiseur/désérialiseur ;
les figures 2 et 2A représentent un exemple de cellule d'un sérialiseur/désérialiseur ;
la figure 3 illustre un exemple de structure de sérialiseur/désérialiseur à repliement selon la présente invention ;
la figure 4 représente un mode de fourniture des signaux de commande pour un sérialiseur/désérialiseur selon la présente invention ;
les figures 5A et 5B illustrent le fonctionnement d'un mode de réalisation de sérialiseur/désérialiseur dans lequel les données série sont sous forme de dibits ; et
la figure 6 représente un exemple de structure à paire de matrices de sérialiseur/désérialiseur repliées et imbriquées selon la présente invention.

Un premier aspect de la présente invention réside dans un agencement specifique des diverses cellules d'une matrice de sérialiseur/désérialiseur pour réduire la surface d'ensemble du circuit.

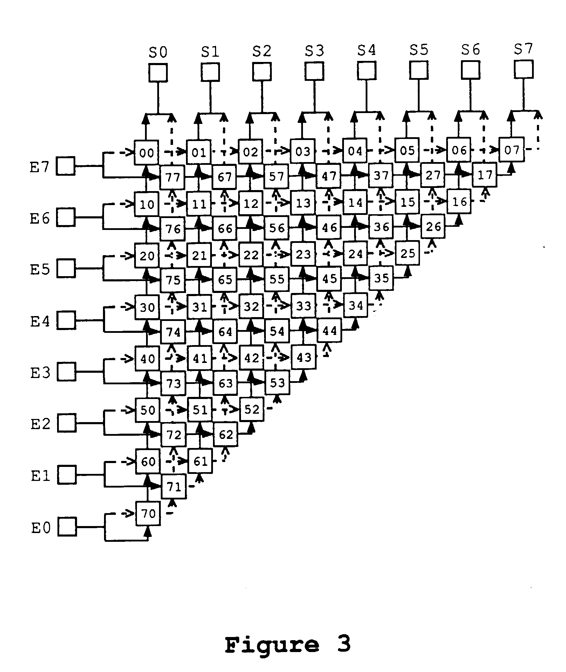

Pour fournir cette réduction dimensionnelle, la présente invention propose, au lieu de disposer les éléments selon une matrice carrée classique, de replier cette matrice par rapport à sa diagonale de la façon illustrée en figure 3. Cette figure 3 est représentée avec le même symbolisme que celui utilisé pour la figure 1 et se comprendra facilement en se rappelant qu'au cours d'un cycle de fonctionnement donné seuls les commutateurs désignés par des flèches en trait plein ou seuls les commutateurs désignés par des flèches en pointillés sont passants.

Il est clair que le dispositif de la figure 3 présente un changement d'agencement par rapport au dispositif de la figure 1 mais a exactement le même fonctionnement. Pour s'en convaincre, on pourrait par exemple suivre le trajet d'un bit arrivant sur l'entrée E4. Lors du premier cycle de fonctionnement, ce bit passera successivement par les registres 30, 31, 32, 33, 34, 35, 36 et 37 pour arriver sur la sortie S4 (en fait il n'arrivera pas sur la sortie S4 puisque, au moment où il devrait y arriver, se produira un changement de mode de fonctionnement). Lors du cycle suivant, les bits successifs arrivant sur l'entrée E4 suivront le chemin des registres 74, 64, 54, 44, 34, 24, 14 et 04 vers la sortie S4 (même remarque).

Grâce à cet agencement, les entrées sont sur une seule colonne et les sorties sur une seule rangée. Chaque borne d'entrée est reliée à deux rangées adjacentes et chaque borne de sortie à deux colonnes adjacentes. On économise donc toute la surface occupée par les connexions en figure 1.

La structure triangulaire selon la présente invention peut paraître surprenante car, quand on place des blocs dans un circuit intégré, chacun est plus ou moins inscrit dans un rectangle et la partie non utilisée d'un bloc triangulaire risque d'être perdue. Toutefois, dans des applications pratiques, un même circuit intégré devra généralement comprendre un sérialiseur et un désérialiseur fonctionnant simultanément. On pourra alors placer dans un rectangle (ou un carré) deux sérialiseurs/désérialiseurs triangulaires tête-bêche. Il en résulte un gain de place important.

La présente invention prévoit également d'apporter diverses modifications au circuit.

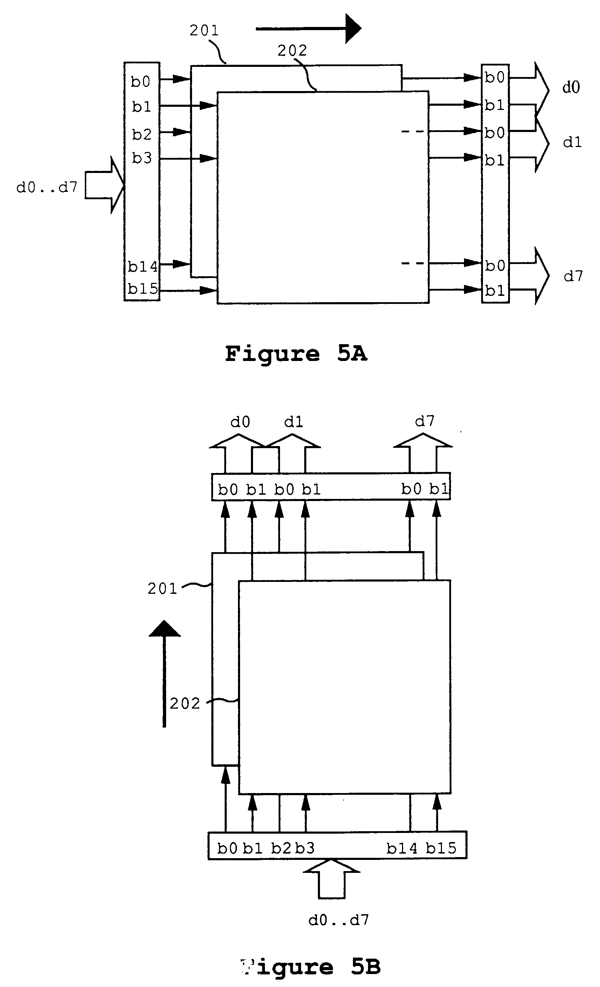

Par exemple, la figure 4 illustre un moyen simple et compatible avec la technologie du dispositif selon l'invention pour obtenir les signaux Q et Q* à partir des signaux d'horloge CLK. Un registre 101 de huit cases (autant de cases que la matrice de la figure 1 a de rangées ou de colonnes) est actionné au rythme de l'horloge CLK du circuit et comprend une entrée de remise à zéro R. La sortie du registre est recouplée à son entrée par un inverseur 102. La sortie du registre correspont également au signal Q susmentionné. Un inverseur 103 fournit le signal Q*. Lors de l'initialisation du système, à l'arrivée du premier mot série ou du premier mot parallèle, le registre 101 est mis à zéro. Au bout de huit coups d'horloge, il ne contiendra que des 1 et les sorties Q et Q* changeront d'état pendant ces huit coups d'horloge. Elles changeront à nouveau d'état pendant les huit coups d'horloge suivants, et ainsi de suite.

Un deuxième aspect de la présente invention réside dans la prévision d'un sérialiseur/désérialiseur dans lequel les données série sont en forme de dibits, c'est-à-dire que les paires de bits successives d'un mot de données série sont groupées dans un même temps d'horloge.

Pour réaliser un sérialiseur/désérialiseur de ce type, on utilise deux matrices de même nature et actionnées de la même façon que ce qui a été décrit précédemment. On introduit dans la première matrice 201 les bits pairs et dans la deuxième matrice 202 les bits impairs d'un mot parallèle dans le cas d'un sérialiseur et le premier et le second de chacun des dibits d'un mot série dans le cas d'un désérialiseur.

Ce circuit et son fonctionnement sont représentés de façon symbolique en figures 5A et 5B, la figure 5A correspondant à un premier cycle de fonctionnement dans lequel on réalise un décalage horizontal et la figure 5B à un deuxième cycle de fonctionnement dans lequel on réalise un décalage vertical, ces deux cycles de fonctionnement étant alternés comme on l'a exposé précédemment. Ces figures sont tracées dans le cas d'un fonctionnement en sérialiseur, mais il sera clair à partir des explications précédentes que la même structure et le même mode de commande font de ce dispositif un désérialiseur si ce sont des données sous forme de dibits série qui sont introduites.

La figure 5A représente le cas où le dispositif est dans son premier cycle de fonctionnement (décalage horizontal) et où les matrices ont déjà été remplies au cours d'un cycle de fonctionnement antérieur.

Des données successives d0 à d7 constituées chacune de 16 bits b0 à b15 en parallèle sont appliquées au circuit de sorte que les bits de rang pair b0, b2 ... b14 sont appliqués aux registres de la première colonne de la première matrice 201 tandis que les bits de rang impair b1, b3 ... b15 sont appliqués aux registres de la première colonne de la deuxième matrice 202. Il apparaît que chacune des matrices a une dimension n x n si les données d'entrée comprennent 2n bits en parallèle. Dans l'exemple représenté, 2n = 16 et n = 8.

Au premier temps d'horloge du cycle, les bits b0-b15 du premier mot d0 Sont introduits dans la colonne de gauche des matrices tandis que, au niveau de la colonne de sortie, les deux premiers bits b0 et b1 de chacun des mots introduits lors du cycle antérieur (décalage vertical) sont extraits simultanément de chacune des matrices 201 et 202 pour former les premiers dibits des mots de données d0 à d7 qui ont été introduits lors du cycle précédant celui décrit.

Lors du deuxième cycle de fonctionnement, illustré en figure 5B, le fonctionnement est le même sauf que les entrées sont appliquées sur la rangée inférieure et les sorties prises sur la rangée supérieure.

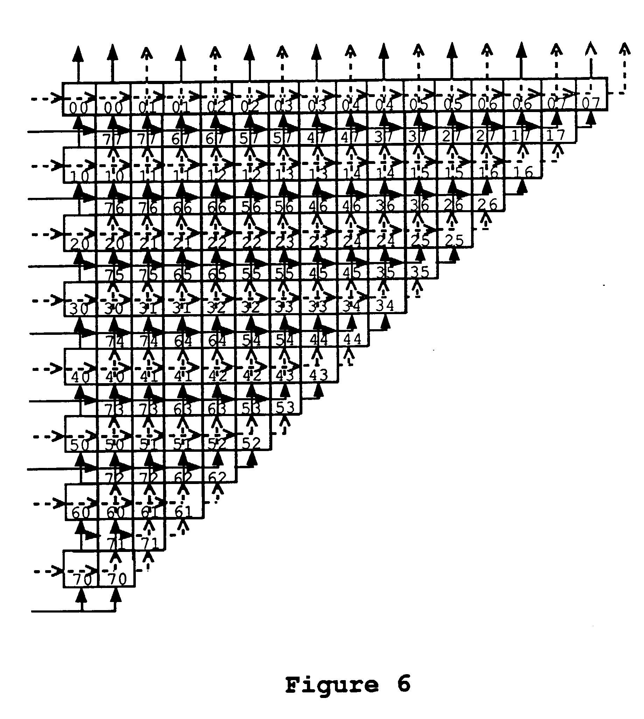

La figure 6 représente un agencement dans lequel les premier et deuxième aspects de l'invention sont combinés. Les données série sont sous forme de dibits et on utilise deux matrices telles que celle de la figure 3 imbriquées. Dans cette représentation, les flèches traversant un carré illustrant un registre indiquent qu'il existe un commutateur entre les deux registres situés de part et d'autre du registre dans lequel figure la flèche.

Par ailleurs, des modes de réalisation d'un registre de 1 bit et d'un commutateur SW1 ou SW2 sont bien connus de l'homme de l'art et n'ont pas décrits en détail ici. On notera toutefois que dans une réalisation en technologie CMOS, les commutateurs SW1 et SW2 seront de préférence réalisés sous forme de portes de transfert constituées de deux transistors MOS de type opposé, c'est-à-dire respectivement à canal N et à canal P, dont l'un est commandé par le signal Q et l'autre par le signal Q*. La différence entre les commutateurs SW1 et SW2 sera que dans l'un c'est le transistor à canal N qui reçoit le signal Q alors que dans l'autre c'est le transistor à canal P qui recevra ce signal, de façon que le fonctionnement des commutateurs SW1 et SW2 soit opposé quand les signaux Q et Q* changent d'état.

## Revendications

1. Sérialisent/désérialiseur de flux de données à n bits décalés au rythme d'une horloge (CLK), comprenant :
une matrice à n rangées et n colonnes de registres de 1 bit (00 - 77) dont chacun est connecté par son entrée à un premier commutateur (SW1) relié à la sortie du registre de la même rangée et de la colonne de rang inférieur et à un deuxième commutateur (SW2) connecté à la sortie du registre de la même colonne et de la rangée de rang supérieur,
des moyens de commande pour fermer alternativement tous les n coups d'horloge les premiers commutateurs et les deuxièmes commutateurs,
des bornes d'entrée (E0 - E7) reliées aux registres de la colonne de rang inférieur et de la rangée de rang supérieur,
des bornes de sortie (S0 - S7) reliées aux registres de la colonne de rang supérieur et de la rangée de rang inférieur,
caractérisé en ce que les cellules de la matrice sont disposées en triangle, les cellules étant disposées les unes par rapport aux autres selon la structure qui correspond à un repliement d'une matrice carrée autour de sa diagonale.

2. Sérialiseur/désérialiseur selon la revendication 1, caractérisé en ce que les moyens de commande comprennent un registre à n cases (101) rebouclé sur lui-même par un inverseur (102) et actionné au rythme de l'horloge (CLK).

3. Sérialiseur/désérialiseur selon la revendication 1, adapté à des flux de données à 2n bits, dans lequel les données série sont sous forme de dibits, caractérisé en ce qu'il comprend deux matrices, les cellules de chaque matrice étant géométriquement disposées en triangle, et les deux structures repliées étant imbriquées, deux entrées de même rang des deux matrices étant associées à deux bits de rang successifs d'un flux de données parallèle ou à un dibit d'un flux de dibits série un dibit étant une paire de bits d'un mot de données.

## Patentansprüche

1. Serialisier-/Deserialisieranordnung zum Serialisieren/Deserialisieren einer Folge von im Rhythmus einer Taktuhr (CLK) verschobenen n-Bit-Daten, umfassend:
- eine n Zeilen und n Spalten aufweisende Matrix von 1-Bit-Registern (00 - 77), deren jedes jeweils durch seinen Eingang mit einem mit dem Ausgang des Registers in derselben Zeile und nächstniederrangigen Spalte verbundenen ersten Schalter (SW1) und mit einem mit dem Ausgang des Registers in derselben Spalte und nächsthöherrangigen Zeile verbundenen Schalter (SW2) verbunden ist,
- Steuermittel zum alternativen Einschalten der ersten und zweiten Schalter jeweils nach n Taktimpulsen,
- Eingangsanschlüsse (E0 - E7), die mit den Registern der niederrangigen Spalte und der höherrangigen Zeile verbunden sind, sowie
- Ausgangsanschlüsse (S0 - S7), die mit den Registern der höherrangigen Spalte und der niederrangigen Zeile verbunden sind,
dadurch gekennzeichnet, daß die Zellen der Matrix in einem Dreieck angeordnet sind, wobei die Zellen relativ zueinander gemäß einer Struktur entsprechend einer Umfaltung einer quadratischen Matrix um ihre Diagonale angeordnet sind.

2. Serialisator/Deserialisator nach Anspruch 1, dadurch gekennzeichnet, daß die Steuermittel ein Register (101) mit n Zellen aufweisen, das durch einen Inverter (102) in sich zurückgekoppelt ist und im Rhythmus der Taktuhr (CLK) betätigt ist.

3. Serialisator/Deserialisator nach Anspruch 1, in Anpassung an Datenflüsse von 2n-Bit-Daten, wobei die Seriendaten in Form von Dibits vorliegen,
dadurch gekennzeichnet, daß er zwei Matrizen aufweist, wobei die Zellen jeder Matrix geometrisch in Form eines Dreiecks angeordnet sind und die beiden umgefalteten Strukturen ineinander verschachtelt sind, derart daß zwei Eingangsgrößen von gleichem Rang der beiden Matrizen zwei Bits von aufeinanderfolgendem Rang eines Paralleldatenflusses oder einem Dibit eines seriellen Dibitflusses zugeordnet sind, wobei ein Dibit ein Bitpaar eines Datenworts ist.

## Claims

1. A serializer/deserializer for a flow of n-bit data shifted according to the rate of a clock (CLK), comprising:
an n-rows and n-columns matrix of 1-bit registers (00-07), each of which is connected through its input to a first switch (SW1) connected to the output of the register in the same row and lower rank column and to a second switch (SW2) connected to the output of the register in the same column and upper rank row,
control means for alternatively switching on the first and second switches every n-clock pulses,
input terminals (E0-E7) connected to the registers of the lower rank column and of the upper rank row, and
output terminals (S0-S7) connected to the registers of the upper rank column and of the lower rank row, wherein the matrix cells are arranged according to a triangle, the cells being arranged one with respect to the other according to the structure corresponding to folding a square matrix along its diagonal.

2. A serializer/deserializer according to claim 1, wherein the control means comprise an n-cells register (101) self-fed back through an inverter (102) and actuated according to the rate of a clock (CLK).

3. A serializer/deserializer according to claim 1, adapted to 2n-bit data flows, wherein the serial data are in the form of dibits, and comprising two matrices, the cells of each matrix being geometrically arranged according to a triangle, and the two folded structures being imbedded, two inputs of a same bit rank of the two matrices being associated to two bits of successive rank of a parallel data flow or to a dibit of a serial dibit flow, a dibit being a bit pair of a data word.
